# EUROPEAN PATENT APPLICATION

(11) **EP 1 734 544 A1**
(43) Date of publication of application: **20.12.2006**
(21) Application number: 05013093.9
(22) Date of filing: 17.06.2005
(51) Int. Cl.: H01F 41/10, H01R 4/14, H01R 13/66, H05K 3/30

(54) **Lead for electronic device for signal transmission**

(71) Applicant: YCL Mechanical Co., Ltd., Niaosong Hsiang Kaohsiung Hsien (TW)
(72) Inventor: Lin, Kuen-Yun, Kaohsiung Hsien (TW)
(74) Representative: Köhler, Walter

(57) **Abstract**

A lead (12) for an electronic device for signal transmission is embedded in a sidewall of a packaging casing (10) of the electronic device and includes two exposed ends to form an inner terminal (13) and an outer terminal (14). The inner terminal (13) includes a winding portion (131) around which a wire (31) of an electronic element (30) of the electronic device is securely wound. The inner terminal (13) further includes a retaining portion (132) adjacent to a distal end of the inner terminal (13). The retaining portion (132) prevents the wire (31) of the electronic element (30) from disengaging from the winding portion (131) of the inner terminal (13).

## Description

### BACKGROUND OF THE INVENTION

### 1. Field of the Invention

The present invention relates to a lead for an electronic device. In particular, the present invention relates to a lead for an electronic device for signal transmission. The present invention also relates to an electronic device having such leads.

### 2. Description of Related Art

A network device or signal transmission device such as a modem, telephone, hub, or adapter for local area network (LAN) comprises at least one connector for providing a complete local area network by a plurality of net lines. A conventional connector for signal transmission comprises a coupler socket with built-in transformer elements for modulating voltage level of the input impulses of the network. In a case that a plurality of identical connectors are mounted in the same network device, the transformer elements of these connectors are integrated to form a packaged transforming device to simplify the structure of the connectors. An example of such a conventional connector is disclosed in, e.g., Taiwan Utility Model Publication No. 408892.

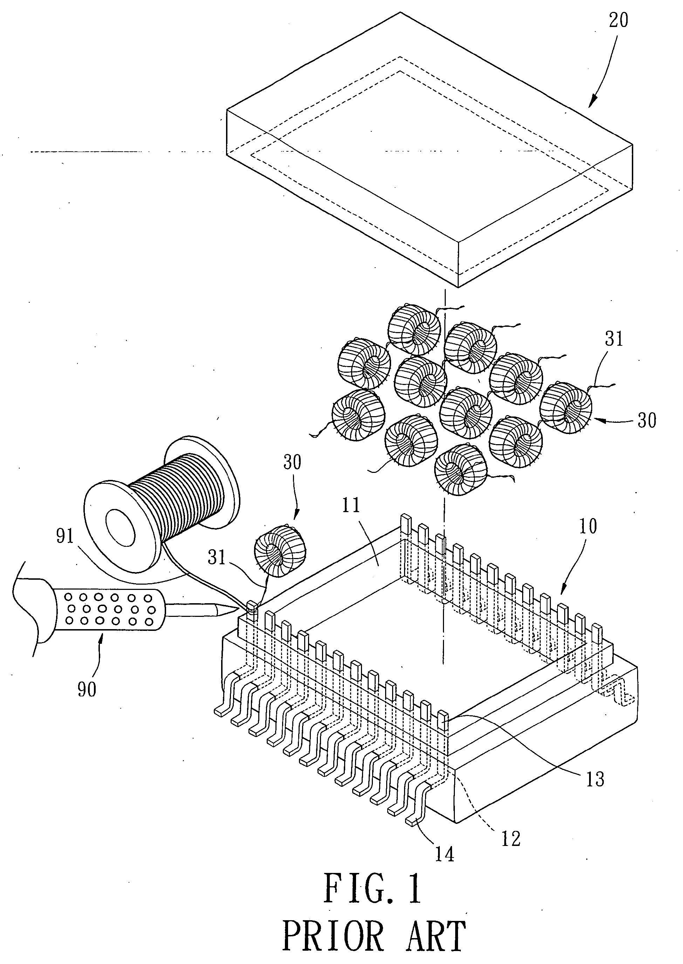

Fig. 1 illustrates a conventional packaged transforming device comprising a packaging casing 10, a packaging cover 20, and a plurality of transformer elements 30. The packaging casing 10 includes a compartment 11, with a plurality of leads 12 mounted in two sidewalls delimiting the compartment 11. Each lead 12 includes an inner terminal 13 and an outer terminal 14. In a conventional procedure for manufacturing the transforming device, an end of a wire 31 of each transformer element 30 is manually welded onto the inner terminal 13 of an associated lead 12 by using a welding gun 90 and solder 91. This procedure requires manually winding the wires 31 around the inner terminals 13 one by one. However, the wires 31 are liable to be disengaged from the respective inner terminals 13, as the inner terminals 13 are smooth metal strips without any retaining or positioning structure, leading to inconvenience to subsequent welding. The unreliable engaging relationship between the wires 31 and the inner terminals 13 may also cause the wires 31 and/or the solder to be disengaged from the respective inner terminals 13 after welding. The qualified product ratio is thus unsatisfactory.

### OBJECTS OF THE INVENTION

An object of the present invention is to provide a lead for an electronic device for signal transmission for providing improved bonding relationship with a wire of an electronic element.

Another object of the present invention is to provide a lead for an electronic device for signal transmission that allows easy welding.

A further object of the present invention is to provide a lead for an electronic device for signal transmission for improving qualified product ratio for the electronic device.

Still another object of the present invention is to provide.an electronic device having such leads.

### SUMMARY OF THE INVENTION

In accordance with an aspect of the invention, a lead for an electronic device for signal transmission is embedded in a sidewall of a packaging casing of an electronic device and comprises two exposed ends to form an inner terminal and an outer terminal. The inner terminal comprises a winding portion around which a wire of an electronic element of the electronic device is securely wound. The inner terminal further comprises a retaining portion adjacent to a distal end of the inner terminal. The retaining portion prevents the wire of the electronic element from disengaging from the winding portion of the inner terminal.

Preferably, the winding portion of the lead is a reduced portion.

Preferably, the retaining portion is formed by punching the inner terminal, and the retaining portion is bent relative to the inner terminal. Preferably, the retaining portion and the inner terminal are substantially V-shaped or Y-shaped.

Preferably, the winding portion is adjacent to a root of the inner terminal.

The electronic element may be a transformer element or a filter.

In accordance with a second aspect of the invention, an electronic device for signal transmission comprises a packaging casing, an electronic element, and at least one lead. The packaging casing comprises a compartment and a sidewall delimiting a portion of the compartment. The electronic element is mounted in the compartment and comprises a wire. The at least one lead is embedded in the sidewall of the packaging casing. The at least one lead comprises two exposed ends to form an inner terminal and an outer terminal. The inner terminal comprises a winding portion around which the wire of the electronic element is securely wound. The inner terminal further comprises a retaining portion adjacent to a distal end of the inner terminal. The retaining portion prevents the wire of the electronic element from disengaging from the winding portion of the inner terminal.

Preferably, the winding portion is a reduced portion.

Preferably, the retaining portion is formed by punching the inner terminal, and the retaining portion is bent relative to the inner terminal.

Preferably, the retaining portion and the inner terminal are substantially V-shaped or Y-shaped.

Preferably, the retaining portion is formed by punching the inner terminal, and the retaining portion is bent and extended toward the compartment.

Preferably, the winding portion is adjacent to a root of the inner terminal.

The electronic element may be a transformer element or a filter.

Other objects, advantages and novel features of this invention will become more apparent from the following detailed description when taken in conjunction with the accompanying drawings.

### BRIEF DESCRIPTION OF THE DRAWINGS

Fig. 1 is an exploded perspective view of an electronic device for signal transmission comprising a plurality of conventional leads;
Fig. 2 is an exploded perspective view of an electronic device for signal transmission with a plurality of leads in accordance with the present invention;
Fig. 3 is a side view illustrating a winding procedure for manufacturing the electronic device in accordance with the present invention;
Fig. 4 is an enlarged view of a circled portion in Fig. 3;
Fig. 5 is a perspective view illustrating a modified embodiment of the electronic device in accordance with the present invention;
Fig. 6 is an enlarged perspective view of a circled portion of the electronic device in Fig. 5; and
Fig. 7 is a view similar to Fig. 6, illustrating a winding procedure for manufacturing the electronic device in accordance with the present invention.

### DETAILED DESCRIPTION OF THE PREFERRED EMBODIMENTS

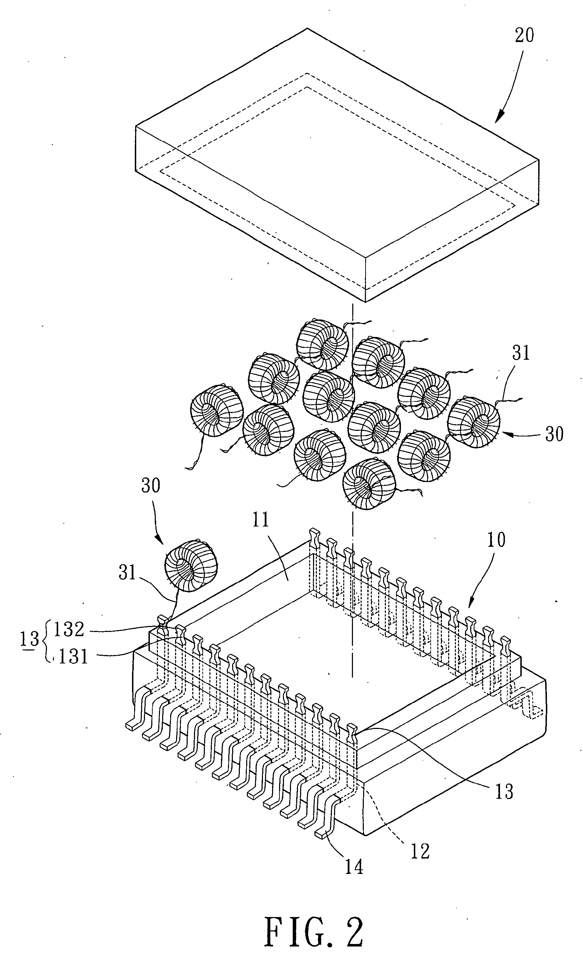

Fig. 2 shows an electronic device for signal transmission in accordance with the present invention. The electronic device comprises a packing casing 10, a packaging cover 20, and at least one electronic element 30 (several electronic elements in this embodiment). Encapsulant is applied after assembly of the packing casing 10, the packaging cover 20, and the electronic elements 30. In the illustrated embodiment, the electronic elements 30 are transformer elements each comprising an iron core wound by an enamel insulated wire. Further, each transformer element 30 comprises at least one wire 31. Nevertheless, the transformer elements 30 can be replaced by filters or other electronic elements, etc, depending on the need of the products.

In the illustrated embodiment, as illustrated in Fig. 2, the packaging casing 10 comprises a compartment 11 for accommodating the electronic elements 30. A plurality of leads 1 are embedded in each of two sidewalls of the packaging casing 10, with two ends of each lead 1 being exposed to form a first terminal 13 and a second terminal 14. The compartment 11 is closed by the packaging cover 10.

Referring to Figs. 2 through 4, each inner terminal 13 includes a winding portion 131 and a retaining portion 132. The winding portion 131 is preferably a reduced portion or a necked portion for allowing reliable winding of the wire 31 of an associated transformer element 30 (electronic element). The retaining portion 132 is adjacent to a distal end of the inner terminal 13 and has a width greater than the winding portion 131 to prevent the wire 31 of the associated transformer element 30 (electronic element) from disengaging from the winding portion 131 of the inner terminal 13.

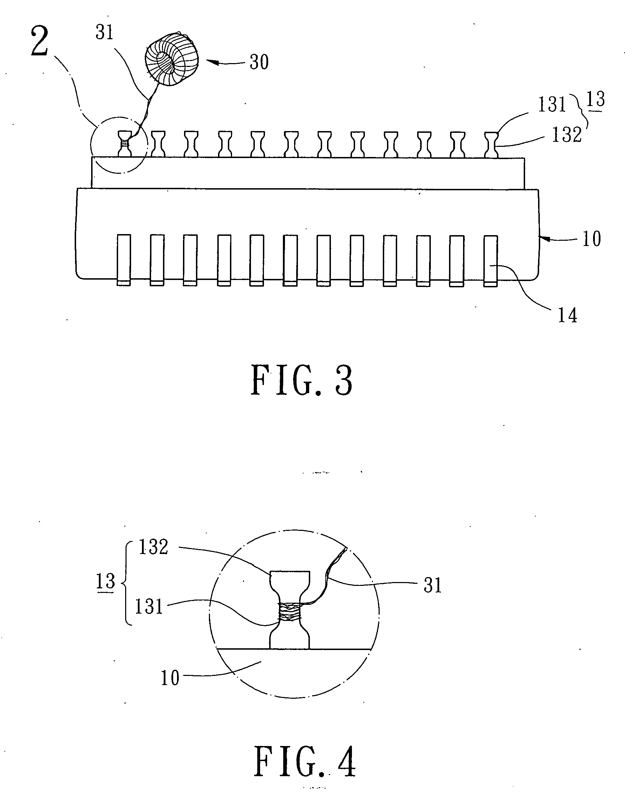

Still referring to Figs. 3 and 4, when the wires 31 of the transformer elements 30 are manually wound one by one onto the respective inner terminals 13, the wires 31 can be reliably wound around the winding portions 132 of the respective inner terminals 13. Since a wider retaining portion 132 is provided on each inner terminal 13, it is unlikely for the wire 31 to pass through the retaining portion 132. Thus, disengagement of the wire 3 from the winding portion 131 is avoided, which is advantageous to subsequent welding. Further, after welding, the wire 31 is still in reliable engaging relationship with the winding portion 131 such that disengagement of the wire 31 and/or solder (not shown) from the inner terminal 13 is less likely to occur, which improves the qualified product ratio of the electronic device for signal transmission.

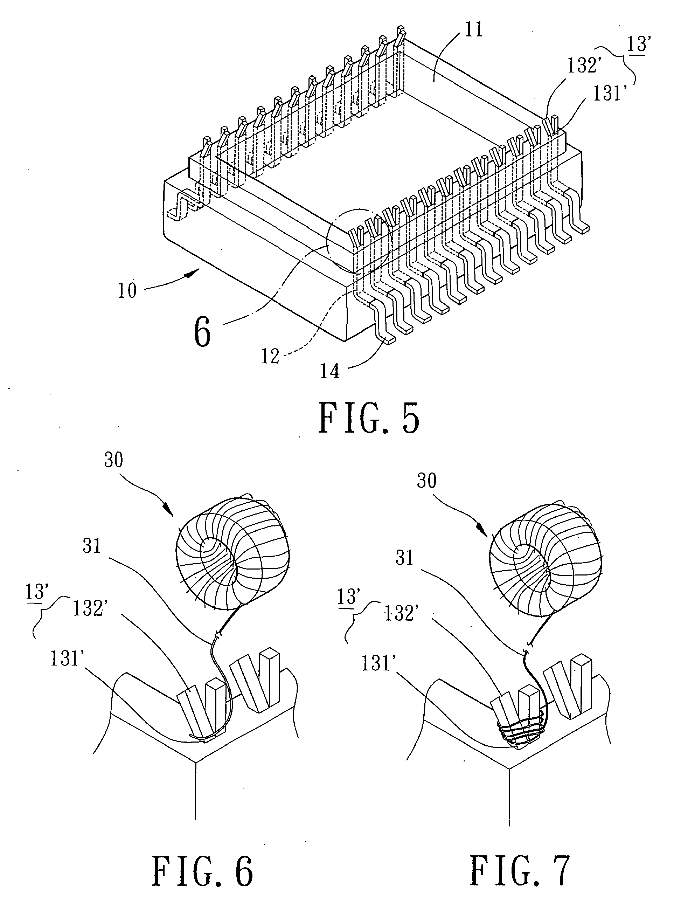

Figs. 5 through 7 illustrate a modified embodiment of the invention, wherein each inner terminal 13' includes a winding portion 131' and a retaining portion 132'. In this embodiment, the retaining portion 132' is formed by punching the inner terminal 13' in a direction toward the compartment 11 such that the retaining portion 132' is bent relative to the inner terminal 13' and extends toward the compartment 11. Thus, the retaining portion 132' and the inner terminal 13' together form a substantially V-shaped or Y-shaped structure. The winding portion 131' is more adjacent to a root of the inner terminal 13' than the retaining portion 132', allowing reliable winding of the wire 31 of the associated transformer element 30 (electronic element) on the winding portion 131'. Further, the retaining portion 132' is more adjacent to a distal end of the inner terminal 13' than the winding portion 131', preventing the wire 31 of the associated transformer element 30 (electronic element) from disengaging from the winding portion 131'.

Still referring to Figs. 6 and 7, when the wires 31 of the transformer elements 30 are manually wound one by one onto the respective inner terminals 13', the wires 31 can be reliably wound around the winding portions 132' of the respective inner terminals 13'. Since a wider retaining portion 132' is provided on each inner terminal 13', it is unlikely for the wire 31 to pass through the retaining portion 132'. Thus, disengagement of the wire 31 1 from the winding portion 131' is avoided, which is advantageous to subsequent welding. Further, after welding, the wire 31 is still in reliable engaging relationship with the winding portion 131' such that disengagement of the wire 31 and/or solder (not shown) from the inner terminal 13' is less likely to occur, which improves the qualified product ratio of the electronic device for signal transmission.

While the principles of this invention have been disclosed in connection with a specific embodiment, it should be understood by those skilled in the art that these descriptions are not intended to limit the scope of the invention, and that any modification and variation without departing the spirit of the invention is intended to be covered by the scope of this invention defined only by the appended claims.

## Claims

1. A lead for an electronic device for signal transmission, the lead being adapted to be embedded in a sidewall of a packaging casing of an electronic device, the lead comprising two exposed ends to form an inner terminal and an outer terminal, the inner terminal comprising a winding portion around which a wire of an electronic element of the electronic device is securely wound, the inner terminal further comprising a retaining portion adjacent to a distal end of the inner terminal, the retaining portion preventing the wire of the electronic element from disengaging from the winding portion of the inner terminal.

2. The lead as claimed in claim 1, with the winding portion of the lead being a reduced portion.

3. The lead as claimed in claim 1, with the retaining portion being formed by punching the inner terminal, and with the retaining portion being bent relative to the inner terminal.

4. The lead as claimed in claim 3, with the retaining portion and the inner terminal being substantially V-shaped.

5. The lead as claimed in claim 3, with the retaining portion and the inner terminal being substantially Y-shaped.

6. The lead as claimed in claim 3, with the winding portion being adjacent to a root of the inner terminal.

7. The lead as claimed in claim 1, with the electronic element being one of a transformer element and a filter.

8. An electronic device for signal transmission, comprising:
a packaging casing comprising a compartment and a sidewall delimiting a portion of the compartment;
an electronic element mounted in the compartment and comprising a wire; and
at least one lead embedded in the sidewall of the packaging casing, said at least one lead comprising two exposed ends to form an inner terminal and an outer terminal, the inner terminal comprising a winding portion around which the wire of the electronic element is securely wound, the inner terminal further comprising a retaining portion adjacent to a distal end of the inner terminal, the retaining portion preventing the wire of the electronic element from disengaging from the winding portion of the inner terminal.

9. The electronic device as claimed in claim 8, with the winding portion being a reduced portion.

10. The electronic device as claimed in claim 8, with the retaining portion being formed by punching the inner terminal, and with the retaining portion being bent relative to the inner terminal.

11. The electronic device as claimed in claim 8, with the retaining portion and the inner terminal being substantially V-shaped.

12. The electronic device as claimed in claim 8, with the retaining portion and the inner terminal being substantially Y-shaped.

13. The electronic device as claimed in claim 8, with the retaining portion being formed by punching the inner terminal, and with the retaining portion being bent and extending toward the compartment.

14. The electronic device as claimed in claim 13, with the winding portion being adjacent to a root of the inner terminal.

15. The electronic device as claimed in claim 8, with the electronic element being one of a transformer element and a filter.
